# EUROPEAN PATENT APPLICATION

(11) **EP 4 626 192 A1**
(43) Date of publication of application: **01.10.2025**
(21) Application number: 23941254.7
(22) Date of filing: 13.10.2023
(51) Int. Cl.: H10K 30/88

(54) **PHOTOVOLTAIC MODULE AND PACKAGING METHOD THEREFOR**

(30) Priority: 16.06.2023 CN 202310723630
(71) Applicant: Trina Solar Co., Ltd, Changzhou, Jiangsu 213031 (CN)
(72) Inventor: XU, Ye, hangzhou, Jiangsu 213031 (CN); ZHANG, Xueling, hangzhou, Jiangsu 213031 (CN)
(74) Representative: Arnold & Siedsma
(86) International application number: PCT/CN2023/124498
(87) International publication number: WO 2024/255030

(57) **Abstract**

The present application relates to a photovoltaic module and an encapsulation method thereof. The photovoltaic module includes a photovoltaic main body (120) and an encapsulation assembly (110). The photovoltaic main body (120) includes a perovskite solar cell layer (121). The encapsulation assembly (110) includes a first substrate (111), a second substrate (112), a first encapsulation portion (113), and a second encapsulation portion (114). The first substrate (111) is located on a side of the photovoltaic main body (120) along a first direction (X). The second substrate (112) is located on another side of the photovoltaic main body (120) along the first direction (X). The first encapsulation portion (113) is disposed around the photovoltaic main body (120). The first encapsulation portion (113) is connected to and located between the first substrate (111) and the second substrate (112). The second encapsulation portion (114) is located on a side of the first encapsulation portion (113) away from the photovoltaic main body (120). The second encapsulation portion (114) is configured to seal end surfaces of the first substrate (111), the second substrate (112), and the first encapsulation portion (113) along a second direction (Y).

## Description

### CROSS-REFERENCE TO RELATED APPLICATIONS

This application claims priority to Chinese patent application No. 2023107236300, entitled "PHOTOVOLTAIC MODULE AND ENCAPSULATION METHOD THEREOF", filed on June 16, 2023. The contents of the application are hereby incorporated herein in its entirety by reference.

### TECHNICAL FIELD

The present application relates to the field of photovoltaic cell technology, particularly to a photovoltaic module and an encapsulation method thereof.

### BACKGROUND

With the development of solar cell technology, improving energy conversion efficiency while reducing device costs has become critical to the large-scale application of solar cell technology. Compared with crystalline silicon cells, perovskite solar cells offer advantages such as solution-based processing, more abundant raw materials, and lower preparation costs. Laboratory single-junction perovskite cells can reach an efficiency of 25.7%, and tandem cells combining perovskite cells with crystalline silicon cells can reach an efficiency of 32%, which makes perovskite cells, or tandem cells incorporating perovskite solar cells, promising candidates for next generation commercial photovoltaic cells.

Due to the unique properties of perovskite solar cells, their photoelectric conversion layers are susceptible to irreversible decomposition and degradation when exposed to moisture, which adversely affects the photoelectric conversion efficiency of the perovskite solar cells. Therefore, in order to ensure the outdoor service life of a photovoltaic module including a perovskite cell, the encapsulation of the cell in the photovoltaic module becomes especially important.

In related art, the photovoltaic module including the perovskite solar cell is typically encapsulated by applying butyl rubber between the upper and lower glass cover plates of the photovoltaic module. During outdoor use, the bonding interface between butyl rubber and the glass is prone to moisture infiltration, which leads to a decreased bonding force between butyl rubber and the glass, causing the butyl rubber to delaminate and separate from the glass. As a result, encapsulation failure occurs in the photovoltaic module, reducing reliability and shortening the service life.

### SUMMARY

In view of this, the present application provides a photovoltaic module and an encapsulation method thereof to improve the reliability of an encapsulation assembly, thereby improving the reliability of the photovoltaic module and prolonging its service life.

In a first aspect, an embodiment of the present application provides a photovoltaic module, including a photovoltaic main body and an encapsulation assembly, wherein the photovoltaic main body includes a perovskite solar cell layer, and the encapsulation assembly includes:
a first substrate located on a side of the photovoltaic main body along a first direction, wherein the first direction is a thickness direction of the photovoltaic module;
a second substrate located on another side of the photovoltaic main body along the first direction;
a first encapsulation portion disposed around the photovoltaic main body, wherein the first encapsulation portion is connected to and located between the first substrate and the second substrate; and
a second encapsulation portion located on a side of the first encapsulation portion away from the photovoltaic main body, wherein the second encapsulation portion is configured to seal end surfaces of the first substrate, the second substrate, and the first encapsulation portion along a second direction, and the second direction is perpendicular to the first direction.

In some embodiments, the end surfaces of the first substrate, the second substrate, and the first encapsulation portion along the second direction are sealingly bonded to the second encapsulation portion; or
the end surfaces of the first substrate and the second substrate along the second direction are sealingly bonded to the second encapsulation portion, and a gap exists between the second encapsulation portion and the first encapsulation portion along the second direction.

In some embodiments, the second encapsulation portion includes a first portion, the first portion is disposed around the first encapsulation portion, and an end surface of the first portion adjacent to the first encapsulation portion is flush with the end surfaces of the first substrate and the second substrate along the second direction.

In some embodiments, the second encapsulation portion further includes a second portion connected to the first portion, the second portion is located on a side of the first portion adjacent to the first encapsulation portion, the second portion extends between the first substrate and the second substrate, and the second portion is disposed around the first encapsulation portion.

In some embodiments, a material of the first encapsulation portion is butyl rubber, silicone adhesive, polyurethane, or epoxy resin.

In some embodiments, a material of the second encapsulation portion is ethylene-vinyl acetate copolymer, ethylene-octene copolymer, polyvinyl butyral, silicone adhesive, acrylic acid, or epoxy resin.

In some embodiments, the photovoltaic main body includes the perovskite solar cell layer and a first adhesive layer, the perovskite solar cell layer is stacked on the first substrate, the first adhesive layer covers a side of the perovskite solar cell layer away from the first substrate, and a side of the first adhesive layer away from the first substrate is bonded to the second substrate.

In some embodiments, an orthographic projection of the first adhesive layer on the first substrate covers an orthographic projection of the perovskite solar cell layer on the first substrate.

In some embodiments, the photovoltaic main body includes the perovskite solar cell layer, a second adhesive layer, a crystalline silicon solar cell layer, and a third adhesive layer, the perovskite solar cell layer is stacked on the first substrate, the second adhesive layer covers a side of the perovskite solar cell layer away from the first substrate, the crystalline silicon solar cell layer is stacked on a side of the second adhesive layer away from the first substrate, the third adhesive layer covers a side of the crystalline silicon solar cell layer away from the first substrate, and a side of the third adhesive layer away from the crystalline silicon solar cell layer is connected to the second substrate.

In some embodiments, an orthographic projection of the second adhesive layer on the first substrate covers an orthographic projection of the perovskite solar cell layer on the first substrate, and an orthographic projection of the third adhesive layer on the first substrate covers an orthographic projection of the crystalline silicon solar cell layer on the first substrate.

In a second aspect, an embodiment of the present application provides a method for encapsulating the photovoltaic module described in the first aspect, including:
placing the photovoltaic main body on the first substrate, the photovoltaic main body including a perovskite solar cell layer;
forming the first encapsulation portion on the first substrate, the first encapsulation portion surrounding the photovoltaic main body;
forming the second encapsulation portion on the side of the first encapsulation portion away from the photovoltaic main body;
placing the second substrate on a side of the photovoltaic main body away from the first substrate; and
laminating the first substrate, the first encapsulation portion, the second encapsulation portion, the photovoltaic main body, and the second substrate, such that the second encapsulation portion seals the end surfaces of the first substrate, the second substrate, and the first encapsulation portion along the second direction.

Details of one or more embodiments of the present application are set forth in the accompanying drawings and description below. Other features, objects, and advantages of the present application will become apparent from the description, drawings, and claims.

### BRIEF DESCRIPTION OF THE DRAWINGS

To illustrate the technical solutions of the present application or the prior art more clearly, the drawings used in the embodiments or in the prior art will be described briefly. Apparently, the following described drawings are merely for the embodiments of the present application, and other drawings can be derived by those of ordinary skill in the art without any creative effort.
FIG. 1 is a schematic structural view of a photovoltaic module in a first type of structure according to some embodiments of the present application.
FIG. 2 is a schematic structural view of a photovoltaic module in a second type of structure according to some embodiments of the present application.
FIG. 3 is a schematic structural view of a photovoltaic module in a third type of structure according to some embodiments of the present application.
FIG. 4 is a schematic structural view of a photovoltaic module in a fourth type of structure according to some embodiments of the present application.
FIG. 5 is a schematic structural view of a photovoltaic module in a fifth type of structure according to some embodiments of the present application.
FIG. 6 is a schematic structural view of a photovoltaic module in a sixth type of structure according to some embodiments of the present application.
FIG. 7 is a schematic structural view of a photovoltaic module in a seventh type of structure according to some embodiments of the present application.
FIG. 8 is a schematic structural view of a photovoltaic module in an eighth type of structure according to some embodiments of the present application.
FIG. 9 shows a flowchart of a method for encapsulating a photovoltaic module according to some embodiments of the present application.

### Reference signs:

10: photovoltaic module, 110: encapsulation assembly, 111: first substrate, 112: second substrate, 113: first encapsulation portion, 114: second encapsulation portion, 1141: first portion, 1142: second portion, 120: photovoltaic main body, 121: perovskite solar cell layer, 122: crystalline silicon solar cell layer, 123: first adhesive layer, 124: second adhesive layer, 125: third adhesive layer, X: first direction, Y: second direction.

### DETAILED DESCRIPTION

The technical solutions of the embodiments of the present application will be described more clearly and comprehensively below in conjunction with the accompanying drawings for the embodiments of the present application. Apparently, the embodiments described herein are only part of, not all of the embodiments of the present application. Base on the embodiments of the present application, other embodiments obtained by those of ordinary skill in the art without creative efforts shall fall within the protection scope of the present application.

In the description of the present application, it should be understood that, the orientation or position relationships indicated by the terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present application and simplify the description only, rather than indicating or implying that the apparatus or element referred to must have a particular orientation or be constructed and operated in a particular orientation, and therefore are not to be interpreted as limiting the present application.

Additionally, the terms "first" and "second" are used for descriptive purposes only, and cannot be construed as indicating or implying a relative importance, or implicitly specifying the number of the indicated technical features. Thus, the feature defined with "first" or "second" may explicitly or implicitly include one or more features. In the description of the present application, "a plurality of" means two or more, such as two, three, etc., unless otherwise defined explicitly and specifically.

In the present application, unless otherwise specified and defined explicitly, the terms "install", "connect", "join", and "fix" should be interpreted in a broad sense. For example, unless otherwise defined explicitly, they may refer to a fixed connection, a detachable connection, or an integrated structure, may refer to a mechanical connection or an electrical connection, and may refer to a direct connection, an indirect connection via an intermediate medium, an internal communication between two elements, or interaction between two elements. The specific meanings of these terms in the present application can be understood based on specific circumstances by those of ordinary skills in the art.

In the present application, unless otherwise specified and defined explicitly, a first feature, when expressed as being "on" or "under" a second feature, may be in direct contact with the second feature or in indirect contact with the second feature via an intermediate medium. Furthermore, a first feature, when expressed as being "over", "above" or "on top of" a second feature, may be located right above or obliquely above the second feature, or only located at a level higher than that of the second feature. A first feature, when expressed as being "below", "underneath" or "under" a second feature, may be located right below or obliquely below the second feature, or only located at a level lower than that of the second feature.

It should be noted that when an element is referred to as being "fixed to" or "arranged on" another element, it may be directly disposed on the other element or an intermediate element may exist. When an element is considered to be "connected to" another element, it may be directly connected to the other element or an intermediate element may exist. The terms "vertical", "horizontal", "upper", "lower", "left", "right" and similar expressions used herein are only for illustrative purposes and are not intended to represent the only implementations.

Due to the unique properties of perovskite solar cells, the photoelectric conversion layers of the perovskite solar cells are susceptible to irreversible decomposition and degradation when exposed to moisture, which adversely affects the photoelectric conversion efficiency of the perovskite solar cells. Therefore, in order to ensure the outdoor service life of a photovoltaic module including a perovskite solar cell, the encapsulation of the cell in the photovoltaic module becomes especially important.

In related art, the photovoltaic module including the perovskite solar cell is typically encapsulated by applying butyl rubber between the upper and lower glass cover plates of the photovoltaic module. During outdoor use, the bonding interface between butyl rubber and the glass is prone to moisture infiltration, which leads to a decreased bonding force between butyl rubber and the glass, causing the butyl rubber to delaminate and separate from the glass. As a result, encapsulation failure occurs in the photovoltaic module, reducing reliability and shortening service life.

In view of the above issues, the present application provides a photovoltaic module and an encapsulation method thereof to improve the reliability of an encapsulation assembly, thereby improving the reliability of the photovoltaic module and prolonging its service life.

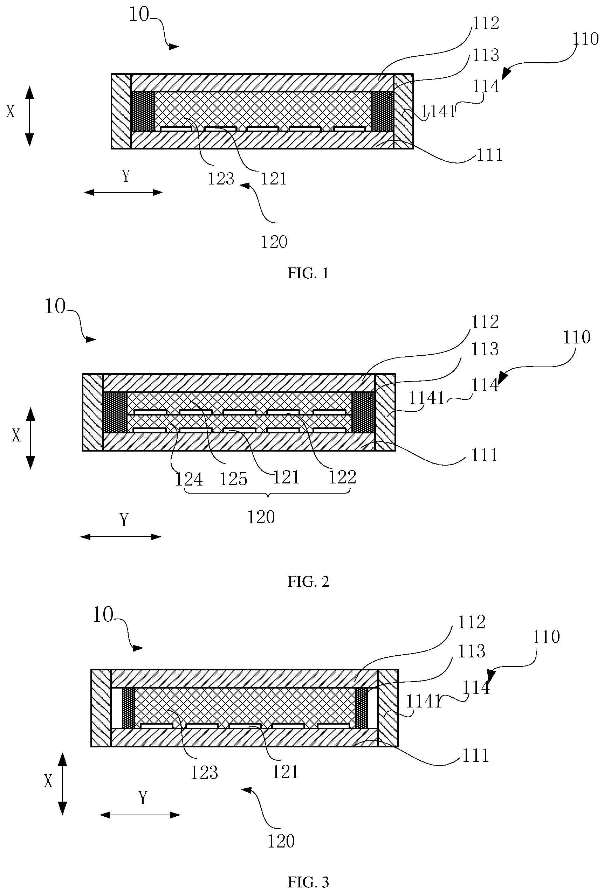

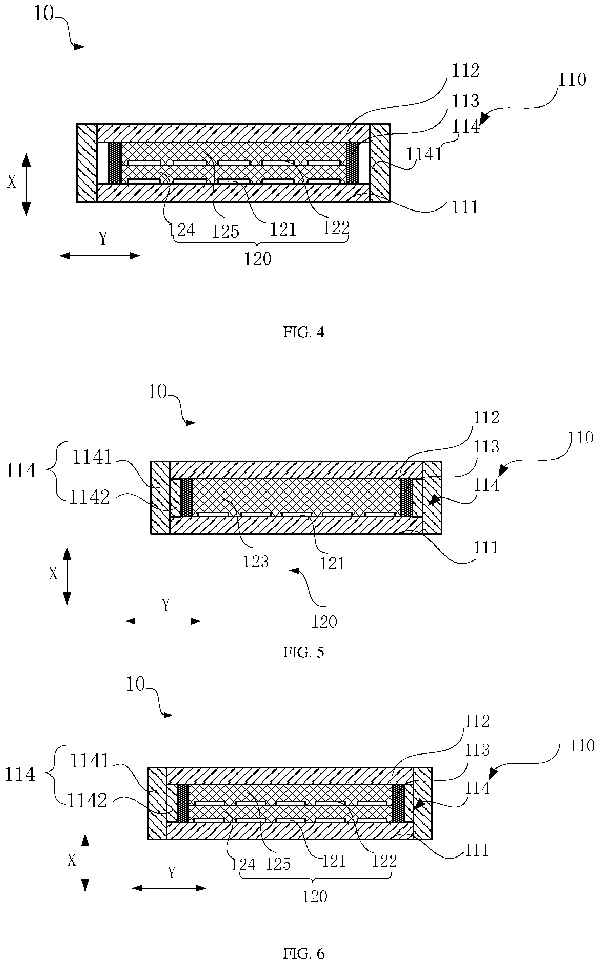

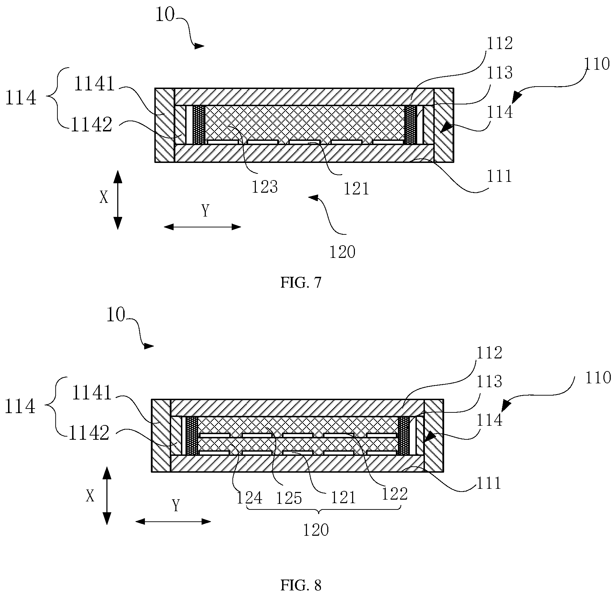

FIG. 1 is a schematic structural view of a photovoltaic module in a first type of structure according to some embodiments of the present application. FIG. 2 is a schematic structural view of a photovoltaic module in a second type of structure according to some embodiments of the present application. FIG. 3 is a schematic structural view of a photovoltaic module in a third type of structure according to some embodiments of the present application. FIG. 4 is a schematic structural view of a photovoltaic module in a fourth type of structure according to some embodiments of the present application. FIG. 5 is a schematic structural view of a photovoltaic module in a fifth type of structure according to some embodiments of the present application. FIG. 6 is a schematic structural view of a photovoltaic module in a sixth type of structure according to some embodiments of the present application. FIG. 7 is a schematic structural view of a photovoltaic module in a seventh type of structure according to some embodiments of the present application. FIG. 8 is a schematic structural view of a photovoltaic module in an eighth type of structure according to some embodiments of the present application.

Referring to FIG. 1 to FIG. 8, in a first aspect, an embodiment of the present application provides a photovoltaic module 10, including a photovoltaic main body 120 and an encapsulation assembly 110. The photovoltaic main body 120 includes a perovskite solar cell layer 121. The encapsulation assembly 110 includes a first substrate 111, a second substrate 112, a first encapsulation portion 113, and a second encapsulation portion 114. The first substrate 111 is located on a side of the photovoltaic main body 120 along a first direction X. The first direction X refers to the thickness direction of the photovoltaic module 10. The second substrate 112 is located on the other side of the photovoltaic main body 120 along the first direction X. The first encapsulation portion 113 is disposed around the photovoltaic main body 120. The first encapsulation portion 113 is connected to and located between the first substrate 111 and the second substrate 112. The second encapsulation portion 114 is located on a side of the first encapsulation portion 113 away from the photovoltaic main body 120. The second encapsulation portion 114 is configured to seal end surfaces of the first substrate 111, the second substrate 112, and the first encapsulation portion 113 along a second direction Y. The second direction Y is perpendicular to the first direction X.

It should be noted that the photovoltaic module 10 generally has a rectangular shape, e.g., the photovoltaic module 10 has two longer edges and two shorter edges. The second encapsulation portion 114 can be disposed on a side of the first encapsulation portion 113 corresponding to either one longer edge or one shorter edge, or the second encapsulation portion 114 can be disposed around the first encapsulation portion 113, depending on actual needs.

In the photovoltaic module 10 provided in the present embodiments of the present application, the first encapsulation portion 113 surrounds the photovoltaic main body 120 and is connected between the first substrate 111 and the second substrate 112. The second encapsulation portion 114 is located on the side of the first encapsulation portion 113 away from the photovoltaic main body 120 and is configured to seal the end surfaces of the first substrate 111, the second substrate 112, and the first encapsulation portion 113. As such, due to the isolation effect of the first encapsulation portion 113, the possibility of moisture penetrating into the second encapsulation portion 114 can be reduced, decreasing the probability of encapsulation failure in the encapsulation assembly 110 caused by moisture infiltration, thereby improving the reliability of the encapsulation assembly 110. Consequently, the reliability of the photovoltaic module 10 can be enhanced, and the service life of the photovoltaic module 10 can be extended.

Referring to FIGS. 1, 2, 5, and 6, in some embodiments, the end surfaces of the first substrate 111, the second substrate 112, and the first encapsulation portion 113 along the second direction Y are sealingly bonded to the second encapsulation portion 114. As such, the bonding strength between the first substrate 111, the second substrate 112, the first encapsulation portion 113, and the second encapsulation portion 114 can be improved, and thus the structural stability of the encapsulation assembly 110 can be improved.

Referring to FIGS. 2, 3, 7, and 8, in some embodiments, the end surfaces of the first substrate 111 and the second substrate 112 along the second direction Y are sealingly bonded to the second encapsulation portion 114. A gap exists between the second encapsulation portion 114 and the first encapsulation portion 113 along the second direction Y. As such, the flow path of moisture toward the second encapsulation portion 114 can be extended, reducing the possibility of moisture penetrating into the second encapsulation portion 114, thereby decreasing the probability of encapsulation failure in the encapsulation assembly 110 due to moisture infiltration. Consequently, the reliability of the photovoltaic module 10 can be enhanced, and its service life can be extended.

Referring to FIG. 1 to FIG. 8, in some embodiments, the second encapsulation portion 114 includes a first portion 1141. The first portion 1141 is disposed around the first encapsulation portion 113. An end surface of the first portion 1141 adjacent to the first encapsulation portion 113 is flush with the end surfaces of the first substrate 111 and the second substrate 112 along the second direction Y. As such, the first portion 1141 can completely isolate the first encapsulation portion 113 from the external environment, thereby reducing the possibility of moisture penetrating into the first encapsulation portion 113 and the photovoltaic main body 120. This further enhances the reliability of the encapsulation assembly 110, and improves the stability of the photovoltaic performance of the perovskite solar cell layer 121. Consequently, the reliability of the photovoltaic module 10 can be enhanced and its service life can be extended.

Referring to FIG. 5 to FIG. 8, in some embodiments, the second encapsulation portion 114 further includes a second portion 1142 connected to the first portion 1141. The second portion 1142 is located on a side of the first portion 1141 adjacent to the first encapsulation portion 113. The second portion 1142 extends between the first substrate 111 and the second substrate 112. The second portion 1142 is disposed around the first encapsulation portion 113. Specifically, a material of the second encapsulation portion 114 is ethylene-vinyl acetate copolymer (EVA), ethylene-octene copolymer (POE), polyvinyl butyral (PVB), silicone adhesive, acrylic acid, or epoxy resin. It can be understood that the material of the second encapsulation portion 114 is not limited to the above materials, and can be other materials.

In some embodiments, the second encapsulation portion 114 includes the first portion 1141 and the second portion 1142. The end surface of the first portion 1141 adjacent to the first encapsulation portion 113 is flush with the end surfaces of both the first substrate 111 and the second substrate 112 along the second direction Y. The second portion 1142 extends between the first substrate 111 and the second substrate 112. As such, the area of the bonding interface between the second encapsulation portion 114 and the first substrate 111, and between the second encapsulation portion 114 and the second substrate 112 can be increased, enhancing the bonding strength between the first substrate 111 and the second substrate 112, and thereby improving the structural stability of the encapsulation assembly 110. Additionally, it further enhances the sealing effect between the second encapsulation portion 114 and both the first substrate 111 and the second substrate 112, thereby effectively improving the reliability of the encapsulation assembly 110. Consequently, the reliability of the photovoltaic module 10 can be enhanced, and its service life can be extended.

In some embodiments, a material of the first encapsulation portion 113 is butyl rubber, silicone adhesive, polyurethane, or epoxy resin. It can be understood that the material of the first encapsulation portion 113 is not limited to the above materials, and can be other materials.

Referring to FIGS. 1, 3, 5, and 7, in some embodiments, the photovoltaic main body includes a perovskite solar cell layer 121 stacked on the first substrate 111, and a first adhesive layer 123 covering a side of the perovskite solar cell layer 121 away from the first substrate 111. A side of the first adhesive layer 123 away from the first substrate 111 is bonded to the second substrate 112. The perovskite solar cell layer 121 can be encapsulated on the first substrate 111 through the first adhesive layer 123, without an adhesive layer disposed between the perovskite solar cell layer 121 and the first substrate 111, which reduces material consumption and lowers production costs. Meanwhile, the first adhesive layer 123 can block moisture infiltration into the perovskite solar cell layer 121, protecting the perovskite solar cell layer 121 and improving the stability of the photovoltaic performance of the cells within the photovoltaic module 10. Additionally, the side of the first adhesive layer 123 away from the first substrate 111 is bonded to the second substrate 112, facilitating the bonding between the photovoltaic main body 120 and both the first substrate 111 and the second substrate 112, thereby enhancing the structural stability of the entire photovoltaic module 10.

It should be noted that the perovskite solar cell layer 121 can include a plurality of perovskite solar cells arranged in an array on the first substrate 111, and the plurality of the perovskite solar cells can be connected in series. The first adhesive layer 123 covers the plurality of perovskite solar cells as well as the portions of the first substrate 111 between adjacent two perovskite solar cells.

In some embodiments, an orthographic projection of the first adhesive layer 123 on the first substrate 111 covers an orthographic projection of the perovskite solar cell layer 121 on the first substrate 111. Specifically, the size of the first adhesive layer 123 in the second direction Y is greater than the maximum size of the perovskite solar cell layer 121 in the second direction Y, and the size of the second adhesive layer 124 in the second direction Y is smaller than the size of the first substrate 111. As such, it can be ensured that the first adhesive layer 123 covers the perovskite solar cell layer 121, protecting the perovskite solar cell layer 121. Meanwhile, the bonding strength between the entire photovoltaic main body 120 and both the first substrate 111 and the second substrate 112 can be improved, thereby improving the structural stability of the entire photovoltaic module 10.

Referring to FIGS. 2, 4, 6, and 8, in some embodiments, the photovoltaic main body 120 includes a perovskite solar cell layer 121, a second adhesive layer 124, a crystalline silicon solar cell layer 122, and a third adhesive layer 125. The perovskite solar cell layer 121 is stacked on the first substrate 111. The second adhesive layer 124 covers a side of the perovskite solar cell layer 121 away from the first substrate 111. The crystalline silicon solar cell layer 122 is stacked on a side of the second adhesive layer 124 away from the first substrate 111. The third adhesive layer 125 covers a side of the crystalline silicon solar cell layer 122 away from the first substrate 111. The side of the third adhesive layer 125 away from the crystalline silicon solar cell layer 122 is connected to the second substrate 112. Stacking the perovskite solar cell layer 121 with the crystalline silicon solar cell layer 122 can maximize the conversion of light energy into electricity, improving the utilization of the solar spectrum, and thus enhancing the efficiency of the photovoltaic module 10. The provision of the second adhesive layer 124 and the third adhesive layer 125 can facilitate the encapsulation and fixation of the perovskite solar cell layer 121 and the crystalline silicon solar cell layer 122, while also improving the bonding of the entire photovoltaic main body 120 with both the first substrate 111 and the second substrate 112, thereby enhancing the structural stability of the photovoltaic module 10.

It should be noted that the crystalline silicon solar cell layer 122 can include a plurality of crystalline silicon solar cell groups arranged in an array on the side of the second adhesive layer 124 away from the first substrate 111. The plurality of crystalline silicon solar cell groups can be connected in series, and each crystalline silicon solar cell group can include a plurality of crystalline silicon solar cells connected in series.

Furthermore, the crystalline silicon solar cell can be an interdigitated back contact (IBC) cell, a heterojunction with intrinsic thin film (HJT) cell, a tunnel oxide passivated contact (TOPCon) cell, a metallization wrapthrough (MWT) cell, or a passivated emitter and rear contact (PERC) cell.

In some embodiments, the circuit loop of the perovskite solar cell layer 121 and the circuit loop of the crystalline silicon solar cell layer 122 are independent from each other.

In some embodiments, an orthographic projection of the second adhesive layer 124 on the first substrate 111 covers an orthographic projection of the perovskite solar cell layer 121 on the first substrate 111, and an orthographic projection of the third adhesive layer 125 on the first substrate 111 covers an orthographic projection of the crystalline silicon solar cell layer 122 on the first substrate 111.

In these embodiments, specifically, the size of the second adhesive layer 124 in the second direction Y is greater than the maximum size of the perovskite solar cell layer 121 in the second direction Y, and the size of the second adhesive layer 124 in the second direction Y is smaller than the size of the first substrate 111. The size of the third adhesive layer 125 in the second direction Y is greater than the maximum size of the perovskite solar cell layer 121 in the second direction Y, and the size of the third adhesive layer 125 in the second direction Y is smaller than the size of the first substrate 111. As such, it can be ensured that the second adhesive layer 124 covers the perovskite solar cell layer 121, and the third adhesive layer 125 covers the crystalline silicon solar cell layer 122, protecting both the perovskite solar cell layer 121 and the crystalline silicon solar cell layer 122. Meanwhile, the bonding strength between the entire photovoltaic main body 120 and both the first substrate 111 and the second substrate 112 can be improved, thereby improving the structural stability of the entire photovoltaic module 10.

In some embodiments, the material of each of the first adhesive layer 123, the second adhesive layer 124, and the third adhesive layer 125 can be ethylene-vinyl acetate copolymer (EVA), ethylene-octene copolymer (POE), polyvinyl butyral (PVB), silicone adhesive, or ethylene-butyl acrylate copolymer (EBA).

In some embodiments, the first substrate 111 can be made of glass, and the second substrate 112 can be made of glass.

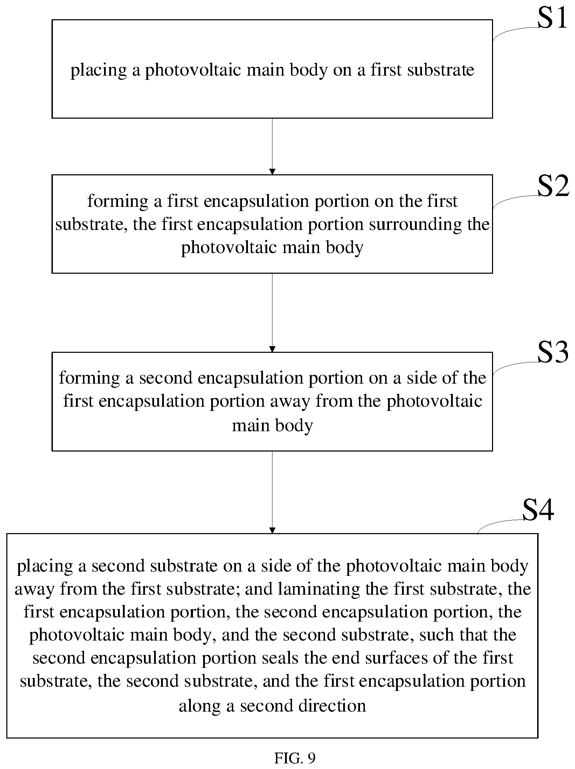

FIG. 9 shows a flowchart of a method for encapsulating a photovoltaic module according to some embodiments of the present application. Referring to FIG. 9, in a second aspect, an embodiment of the present application provides a method for encapsulating the photovoltaic module described in the first aspect, including:
S1: placing the photovoltaic main body 120 on the first substrate 111, the photovoltaic main body 120 including a perovskite solar cell layer 121;
S2: forming the first encapsulation portion 113 on the first substrate 113, the first encapsulation portion surrounding the photovoltaic main body;
S3: forming the second encapsulation portion 114 on the side of the first encapsulation portion 113 away from the photovoltaic main body 120;
S4: placing the second substrate 112 on the side of the photovoltaic main body 120 away from the first substrate 111; and laminating the first substrate 111, the first encapsulation portion 113, the second encapsulation portion 114, the photovoltaic main body 120, and the second substrate 112, such that the second encapsulation portion 114 seals the end surfaces of the first substrate 111, the second substrate 112, and the first encapsulation portion 113 along the second direction Y.

In the photovoltaic module 10 obtained through the encapsulation method in the above embodiment, the first encapsulation portion 113 surrounds the photovoltaic main body 120, and the first encapsulation portion 113 is connected to and located between the first substrate 111 and the second substrate 112. The second encapsulation portion 114 is located on the side of the first encapsulation portion 113 away from the photovoltaic main body 120 and is configured to seal the end surfaces of the first substrate 111, the second substrate 112, and the first encapsulation portion 113. As such, due to the isolation effect of the first encapsulation portion 113, the possibility of moisture penetrating into the second encapsulation portion 114 can be reduced, decreasing the probability of encapsulation failure in the encapsulation assembly 110 due to moisture infiltration, thereby improving the reliability of the encapsulation assembly 110. Consequently, the reliability of the photovoltaic module 10 can be enhanced, and the service life of the photovoltaic module 10 can be extended.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A photovoltaic module, comprising a photovoltaic main body and an encapsulation assembly, wherein the photovoltaic main body comprises a perovskite solar cell layer, and the encapsulation assembly comprises:
a first substrate located on a side of the photovoltaic main body along a first direction, the first direction being a thickness direction of the photovoltaic module;
a second substrate located on another side of the photovoltaic main body along the first direction;
a first encapsulation portion disposed around the photovoltaic main body, the first encapsulation portion being connected to and located between the first substrate and the second substrate; and
a second encapsulation portion located on a side of the first encapsulation portion away from the photovoltaic main body, the second encapsulation portion being configured to seal end surfaces of the first substrate, the second substrate, and the first encapsulation portion along a second direction, the second direction being perpendicular to the first direction.

2. The photovoltaic module according to claim 1, wherein the end surfaces of the first substrate, the second substrate, and the first encapsulation portion along the second direction are sealingly bonded to the second encapsulation portion, or
the end surfaces of the first substrate and the second substrate along the second direction are sealingly bonded to the second encapsulation portion, and a gap exists between the second encapsulation portion and the first encapsulation portion along the second direction.

3. The photovoltaic module according to claim 1 or 2, wherein the second encapsulation portion comprises a first portion, the first portion is disposed around the first encapsulation portion, and an end surface of the first portion adjacent to the first encapsulation portion is flush with the end surfaces of the first substrate and the second substrate along the second direction.

4. The photovoltaic module according to claim 3, wherein the second encapsulation portion further comprises a second portion connected to the first portion, the second portion is located on a side of the first portion adjacent to the first encapsulation portion, the second portion extends between the first substrate and the second substrate, and the second portion is disposed around the first encapsulation portion.

5. The photovoltaic module according to claim 1, wherein a material of the first encapsulation portion is butyl rubber, silicone adhesive, polyurethane, or epoxy resin.

6. The photovoltaic module according to claim 1, wherein a material of the second encapsulation portion is ethylene-vinyl acetate copolymer, ethylene-octene copolymer, polyvinyl butyral, silicone adhesive, acrylic acid, or epoxy resin.

7. The photovoltaic module according to claim 1, wherein the photovoltaic main body comprises:
a perovskite solar cell layer stacked on the first substrate, and
a first adhesive layer covering a side of the perovskite solar cell layer away from the first substrate, a side of the first adhesive layer away from the first substrate being bonded to the second substrate.

8. The photovoltaic module according to claim 7, wherein an orthographic projection of the first adhesive layer on the first substrate covers an orthographic projection of the perovskite solar cell layer on the first substrate.

9. The photovoltaic module according to claim 1, wherein the photovoltaic main body comprises:
a perovskite solar cell layer stacked on the first substrate;
a second adhesive layer covering a side of the perovskite solar cell layer away from the first substrate;
a crystalline silicon solar cell layer stacked on a side of the second adhesive layer away from the first substrate; and
a third adhesive layer covering a side of the crystalline silicon solar cell layer away from the first substrate, a side of the third adhesive layer away from the crystalline silicon solar cell layer being connected to the second substrate.

10. The photovoltaic module according to claim 9, wherein an orthographic projection of the second adhesive layer on the first substrate covers an orthographic projection of the perovskite solar cell layer on the first substrate, and
an orthographic projection of the third adhesive layer on the first substrate covers an orthographic projection of the crystalline silicon solar cell layer on the first substrate.

11. A method for encapsulating the photovoltaic module according to any one of claims 1 to 10, comprising:
placing the photovoltaic main body on the first substrate;
forming the first encapsulation portion on the first substrate, the first encapsulation portion surrounding the photovoltaic main body;
forming the second encapsulation portion on the side of the first encapsulation portion away from the photovoltaic main body;
placing the second substrate on a side of the photovoltaic main body away from the first substrate; and
laminating the first substrate, the first encapsulation portion, the second encapsulation portion, the photovoltaic main body, and the second substrate, such that the second encapsulation portion seals the end surfaces of the first substrate, the second substrate, and the first encapsulation portion along the second direction.
